# EUROPÄISCHE PATENTSCHRIFT

(11) **EP 0 528 350 B1**
(45) Veröffentlichungstag und Bekanntmachung des Hinweises auf die Patenterteilung: **02.07.1997**
(21) Anmeldenummer: 92113750.1
(22) Anmeldetag: 12.08.1992
(51) Int. Cl.: H05K 3/34

(54) **Verfahren zum Beloten und Montieren von Leiterplatten mit Bauelementen**
Method for soldering and mounting components on circuit boards
Méthode de soudage et montage de composant sur plaquettes de circuits imprimés

(30) Priorität: 14.08.1991 DE 4126913
(43) Veröffentlichungstag der Anmeldung: 24.02.1993
(73) Patentinhaber: SIEMENS AKTIENGESELLSCHAFT, 80333 München (DE)
(72) Erfinder: Maiwald, Werner, Dipl.-Physiker, W-8202 Bad Aibling (DE)

(56) Entgegenhaltungen:
- EP-A- 0 322 121
- GB-A- 2 037 489
- US-A- 4 752 027
- RADIO FERNSEHEN ELEKTRONIK Bd. 36, Nr. 8, 1987, BERLIN Seiten 479 - 483 PROF. DR.SC.TECHN. MANFRED KUNZE 'baugruppenrationalisierung und oberfl chenmontage'
- PATENT ABSTRACTS OF JAPAN, Bd. 15, Nr. 315 12. August 1991 & JP-A-31 16 994

## Beschreibung

Die Erfindung betrifft ein Verfahren zum Beloten und Montieren von Leiterplatten mit Bauelementen nach dem Oberbegriff des Patentanspruchs 1.

Ein derartiges, aus der EP-A-0 322 121 bekanntes Verfahren erfordert eine umständliche und kostspielige Vorbehandlung der Anschlüsse des Bauelements zur Erzeugung von Lotdepots.

Bei der Fertigung elektronischer Baugruppen hat die Oberflächenmontierung von Bauelementen gegenüber der Kontaktlochmontierung von Bauelementen eine wesentliche Bedeutung erlangt. Die höhere Packungsdichte oberflächenmontierter Bauelemente (SMC, Surface Mount Components) auf gedruckten Leiterplatten (PCB, Printed Circuits Bords) erfordert reduzierte Abstände zwischen den Bauelementen sowie kleinere Abmessungen der Lötpunkte und deshalb eine höhere Anzahl von Lötpunkten auf jeder Leiterplatte, Daraus und durch die schwierige Leiterplattenkontrolle ergibt sich ein Zwang zu einem möglichst perfekten Verlöten der Bauelemente. Darüber hinaus kommt bei der Oberflächenmontage von Bauelementen der Qualität der beim Lötvorgang verwendeten Materialien eine größere Bedeutung zu als bei konventionellen Lötverfahren.

Konventionelle Wellenlötprozesse, wie sie beispielsweise bei der Bestückung von Leiterplatten mit in Montagelöchern eingesetzten Bauelementen verwendet werden, eignen sich nur bedingt für die Zwecke der Oberflächenmontage von Bauelementen. Bei den vorzugsweise mit einem Kleber auf der Leiterplatte befestigten Bauelementen erfolgt beim Wellenlöten die Belotung durch einen Lotschwall, der auf der Rückseite der Leiterplatte zugeführt wird. Das Auftragen des Lots und die Herstellung einer Lötverbindung mit den Anschlußkontakten des Bauelements erfolgt dabei gleichzeitig, da das Lot schmelzflüssig ist. Probleme bei der Durchführung des Verfahrens, beispielsweise durch Oxidation des Lots, sowie die zunehmend verkleinerten Abmessungen führen dazu, daß mit diesem Verfahren bei oberflächenmontierten Bauelementen keine ausreichend zuverlässigen Lötverbindungen erreicht werden.

In der Oberflächenmontagetechnik (SMT, Surface Mounted Technology) bieten direkt verarbeitbare Leiterplatten große Vorteile. Dabei werden vorbelotete reflow-lötfähige SMD-Leiterplatten unmittelbar mit SMD-Bauelementen bestückt. Die Kontakt- oder Leiteranschlüsse der Bauelemente werden in Bezug auf entsprechende Kontaktanschlüsse eines Substrats bzw. der Leiterplatte ausgerichtet und nach dem Reflow-Lötverfahren verlötet. Das Lot muß dabei eine ausreichende Qualität besitzen, um die Kontaktanschlüsse des Bauelements zu benetzen und alle Zwischenräume zwischen den Kontaktanschlüssen des Bauelements und der Leiterplatte zu schließen.

Aus der DE-PS 38 10 653 sind mehrere Methoden zur Belotung von Leiterplatten mit Bauelementen bekannt. Bei der Tauchbelotung von Leiterplatten wird eine vorbereitete Leiterplatte in ein Lotbad eingetaucht und dann herausgenommnen und abgekühlt. Die nicht mit einem Lötstoppmittel versehenen metallisierten Bereiche der Leiterplatte erhalten dabei einen Lotauftrag. Dabei ergeben sich allerdings aufgrund der Oberflächenspannung des Lots gekrümmte Oberflächen, etwa in Form eines Buckels. Die Höhe des Lotauftrags hängt von den Dimensionen in Leiterplattenebene ab, so daß unterschiedliche hohe Lotaufträge entstehen. Ein nachfolgendes Nivelierungsverfahren mit Hilfe eines Heißluftstroms ist sehr aufwendig und problembehaftet, da es z.B. Flußmittel verwendet, deren Entsorgung in der Zukunft teuer wird. Ein Umgrenzen der elektrisch leitfähigen Bereiche (Lötpads) der Leiterplatte mit einer eine Belotung verhindernden Begrenzungsschicht definierter Dicke, um die so vorbereitete Leiterplatte noch im Tauchbad mit einem Abschlußelement abzudecken, so daß nach dem Austauchen und Abkühlen gleichmäßig hohe Lotaufträge entstehen, weist einige Nachteile auf. So muß die Begrenzungsschicht entweder mechanisch oder chemisch von der Oberfläche der Leiterplatte wieder entfernt werden. Dieses Verfahren ist deshalb sehr aufwendig, da von einer temporären Lötstoppmaske Gebrauch gemacht wird, die gleichzeitig entfernbar und hitzebeständig sein muß. Außerdem bedingt der Tauchvorgang eine erhebliche Temperaturbelastung der Leiterplatte. Schließlich kann die chemische Ablösung der Begrenzungsschicht, z.B. durch einen alkalischen Waschvorgang, eventuell zu Folgeschäden führen.

Bekannt ist weiterhin ein Verfahren, bei dem auf die SMD-Lötbereiche bzw. Lötpads mit Hilfe eines Druckverfahrens (z.B. Siebdruck) oder eines Dosierverfahrens Lotpaste aufgebracht wird, die flächenförmige Lotdepots bildet. Zur Vermeidung von Kontaktbrücken ist beispielsweise aus Patent Abstracts of Japan, Vol. 14, No. 336 (E-953) |4279|, 19. Juli 1990 bekannt, zwischen den Lötpads eine Lötstoppmaske aufzubringen. Nach dem Bestücken der mit den Lotdepots versehenen gedruckten Leiterplatte mit Bauelementen werden die Lotdepots dann im Reflow-Ofen relativ langsam bis über den Schmelzpunkt der jeweiligen Lotlegierung erwärmt und so durch Aufschmelzen der Lotpaste die Lotverbindung hergestellt. Dieses Verfahren ist jedoch insbesondere deshalb problematisch, da die Lotpaste nicht massiv ist, sondern einen hohen Anteil flüchtiger nicht metallischer Bestandteile, wie z.B. Lösemittel enthält. Das inhomogene Lotangebot kann beim Löten zu Lötstellen verminderter Qualität führen und verlängert außerdem den Prozeßablauf, da die flüchtigen Bestandteile durch langsames Erhitzen allmählich ausgedampft werden müssen.

Aus der US-PS 4,752,027 ist ein Verfahren zum Beloten von Leiterplatten mit Bauelementen bekannt, bei dem auf Lötpads durch Siebdruck oder Matrizendruck Lotpaste aufgebracht, anschließend im Ofen getrocknet und reflow-behandelt wird. Das damit erhaltene Muster auf der Leiterplatte mit konvexen Lötpunkten wird sorgfältig gereinigt, bevor die Leiterplatte mit Rollen bearbeitet wird, die die Oberflächen der Lötpunkte flachdrücken und nivellieren. Anschließend wird auf die Lötpunkte adhäsives Flußmittel aufgebracht, um auf diese Weise bei der Bestückung der so vorbehandelten Leiterplatte mit Bauelementen einen Adhäsionskontakt zwischen den Lötpunkten und den Anschlüssen des Bauelements herzustellen. Bei dieser Methode, Bauelemente mit dem Flußmittel, beispielsweise Kolophonium auf den Lötpads festzukleben, kann sich insbesondere bei kleinen Bauelementen die Schwierigkeit ergeben, daß diese sich, beispielsweise durch Unsymmetrien, aufstellen können. In diesem Fall ist keine Belotung oder eine schlechte Belotung der dann in der Luft befindlichen Anschlußkontakte des Bauelements möglich, so daß eine fehlerhafte Lötverbindung entsteht. Besonders ausgeprägt wird dieser Effekt beim beidseitigen Bestücken einer Leiterplatte. Weiterhin ist die entsprechend vorbehandelte Leiterplatte nur innerhalb einer begrenzten Zeit von etwa einem Tag verarbeitbar, da die auf den Lötpads befindlichen festen Lötanteile sowie das Flußmittel mit Klebeanteilen wegen des notwenigen Aufschmelzens nur innerhalb dieser Zeit optimale Lötbedingungen bieten. Darüber hinaus ist nach dem Lötvorgang ein Waschen der bestückten und verlöteten Leiterplatte mit Bauelementen erforderlich, um die Flußmittelrückstände zu entfernen. Dies bedeutet bei entsprechenden Stückzahlen wegen der Waschmittelzusätze eine erhebliche Belastung der Umwelt.

Der Erfindung liegt die Aufgabe zugrunde, ein Verfahren zum Beloten und Montieren von Leiterplatten mit Bauelementen anzugeben, das die vorstehenden Verfahren verbessert.

Diese Aufgabe wird erfindungsgemäß mit den Merkmalen des Patentanspruchs 1 gelöst.

Die Erfindung hat den Vorteil, daß alle, auch kleine Bauelemente vor dem Lötvorgang so sicher mit der Leiterplatte verbunden werden, daß gute und zuverlässige Lötverbindungen hergestellt werden können. Darüber hinaus ergibt sich der Vorteil, daß die mit der Leiterplatte verbundenen Bauelemente mit einem Low-Solid (LS)-Flußmittel behandelt werden können, so daß nach dem Lötvorgang ein Waschen der Baugruppenanordnung nicht mehr erforderlich ist und somit das Verfahren insgesamt vereinfacht wird. Darüber hinaus wird das mit der Leiterplatte verbundene Bauelement beim Tauchen ebenfalls mit Flußmittel benetzt, woraus sich eine Verbesserung der Lötstelle ergibt. Beiseitig bestückte Leiterplatten ermöglichen einen Flußmittelauftrag und ein Durchführen des Lotvorgangs auf beiden Plattenseiten gleichzeitig. Schließlich ermöglicht das erfindungsgemäße Verfahren längere Verarbeitungszeiten, da das Auftragen und die Ausbildung von Lotdepots z. B. mit Hilfe einer Lotpaste, einschließlich der Verbindung der Leiterplatte mit Bauelementen unabhängig vom Auftrag des Flußmittels erfolgen kann. Daraus ergibt sich eine einfachere Prüfung nach den einzelnen Verfahrensschritten. Einschränkungen gegenüber bisher bekannten Verfahren ergeben sich nicht, da prinzipiell jedes Flußmittel verwendet werden kann, so daß bei problematisch lötbaren Bauelementen auch weiterhin aggressive Flußmittel eingesetzt werden können, wobei allerdings ein Waschen der Leiterplatte nach dem Lötvorgang erforderlich wird. Vorzugsweise eignet sich die Erfindung für SMD-Bauelemente, obwohl sich auch andere Bauelemente einsetzen lassen.

Ausgestaltungen der Erfindung sind in Unteransprüchen gekennzeichnet.

Die Erfindung wird anhand eines Ausführungsbeispiels unter Bezugnahme auf die beigefügte Zeichnung näher erläutert. Es zeigen:
- Figur 1: eine schematische Schnittdarstellung einer Leiterplatte mit Lotdepots und
- Figur 2: eine schematische Schnittdarstellung einer Leiterplatte mit fertig verlötetem SMD-Bauelement.

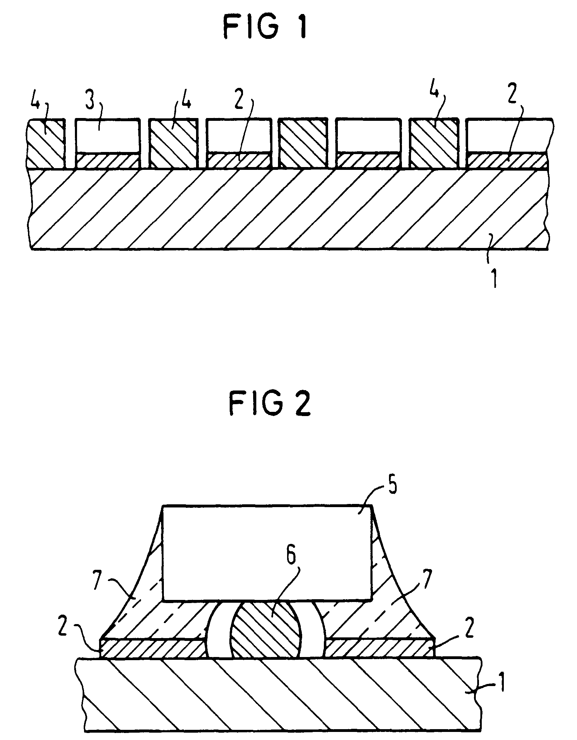

Die in Figur 1 dargestellte belotete Leiterplatte 1 besteht zunächst aus einem Basismaterial, auf das in den als SMD-Lötbereichen vorgesehenen Stellen eine leitfähige Kupferkaschierung 2 (Lötpads) in an sich bekannter Weise aufgebracht ist. Die Lötpads 2 können durch eine Lötstoppmaske 4 aus Kunststoff begrenzt werden. Auf den Lötpads 2 werden Lotdepots aufgebracht. Dies kann mit Lotpaste oder mit beliebigen Lotlegierungen z. B. mit Hilfe von Drucksieben oder Metallschablonen im Rahmen der bekannten und kostengünstigen Druckverfahren erfolgen. Es ist jedoch auch ein punktueller Auftrag z. B. von Lotpaste mit Hilfe eines Dosiergeräts (Despenser) möglich. Die flächenförmigen Lotdepots werden anschließend zur Verbindung mit dem Lötpad vorzugsweise aufgeschmolzen, beispielsweise durch Infrarotstrahlung oder durch erhitzten Dampf. Bei diesem Vorgang entweichen die flüchtigen Bestandteile aus dem Lotdepot, so daß ein weitgehend massiver, mit dem jeweiligen Lötpad fest verbundener Lotauftrag entsteht, der jedoch aufgrund der Oberflächenspannung insbesondere an seiner Oberfläche stark gekrümmt sein kann. Sofern die zusätzliche Forderung besteht, daß die Lotaufträge nivelliert sein müssen, kann der buckelförmige Lotauftrag mit einer Vorrichtung, wie einer Presse oder Walze flachgedrückt werden, wobei eventuell zugeführte Wärme diesen Vorgang unterstützen kann. Dabei kann das Lot in die flüssige oder teigige Phase gebracht werden, wozu vorteilhafterweise eine nicht eutektische Lötpaste Verwendung findet. Durch diesen Verfahrensschritt kann das Flachpressen einzelner, gleichzeitig mehrerer oder aller Lotaufträge der Leiterplatte auf einfache Weise erfolgen. Es resultiert eine an ihrer Oberfläche relativ ebene massive Lotschicht 3. Trotz des Aufschmelzens ist die endgültige Form der fertigen Lotaufträge, also die Schicht 3 gemäß Figur 1 wieder vergleichsweise flächenförmig. In den Fällen, in denen eine vergleichsweise ebene, weitgehend nivellierte Oberfläche der Lotaufträge der Lotpads nicht erforderlich ist, kann gleichwohl nach dem Aufschmelzen der Lotdepots nach dem erfindungsgemäßen Verfahren weitergearbeitet werden.

Nach der Herstellung und dem Verbinden der Lotdepots mit den Lötpads sieht das erfindungsgemäße Verfahren vor, die Bauelemente mit Hilfe eines Klebstoffs mit der Leiterplatte zu verbinden, wobei der Klebstoff auf der Leiterplatte zwischen jeweils einem Bauelement zuordnenbaren elektrisch leitfähigen Bereichen aufgebracht wird (Figur 2). Das Bauelement 5 wird dabei mit Hilfe eines Klebstoffs 6 auf der Leiterplatte 6 befestigt. Der Klebstoff 6 befindet sich zwischen den gemäß Figur 1 mit Lotaufträgen versehenen Lötpads 2. Wenn der Lotauftrag ohne Verwendung einer Lötstoppmaske erfolgt ist, kann der Klebstoff direkt auf der Leiterplatte aufgebracht werden. Wurde eine Lötstoppmaske verwendet, so kann diese je nach Anforderungen und Vorbereitung der Lotaufträge entweder vor dem Aufbringen des Klebstoffs entfernt werden oder aber der Klebstoff auf den Bereichen der Lötstoppmaske 4 aufgebracht werden, die zwischen Lotaufträgen liegen und einem Bauelement zugeordnet werden können.

In der Ausführungsform gemäß Figur 2 ist keine Lötstoppmaske verwendet oder eine verwendete Lötstoppmaske wieder entfernt worden. Damit kann das Bauelement 5 durch den Klebstoff 6 direkt mit der Leiterplatte verbunden werden, wobei der Klebstoff entweder zuerst auf die Leiterplatte aufgebracht und danach das Bauelement 5 aufgesetzt wird oder aber der Klebstoff zuerst mit dem Bauelement 5 verbunden wird und danach das Bauelement 5 mit Klebstoff 6 auf die entsprechenden Bereiche der Leiterplatte aufgebracht wird. Vorzugsweise wird das Bauelement so plaziert, daß die Zuordnung der zu verlötenden Anschlüsse zu den Lötpads im Hinblick auf das spätere Lötverfahren optimal ist. Nach dem Aufbringen des Bauelements wird vorzugsweise der Klebstoff 6 ausgehärtet, so daß eine weitgehend stabile und feste Verbindung zwischen Bauelement 5 und Leiterplatte 1 besteht. Je nach Anwendungszweck können mehrere Klebepunkte oder aber pro Bauelement nur ein Klebepunkt vorgesehen sein. Ebenso wie zuvor die Lotpaste kann auch der Klebstoff mit einer Maske, beispielsweise über ein Druckverfahren oder mit einem Dosiergerät aufgetragen werden.

Die Verwendung einer permanenten Lötstoppmaske hat den Vorteil, daß aufgeklebte Bauelemente, z.B. zweipolige SMD-Bauelemente, direkt auf der Lötstoppmaske aufliegen können und deshalb der Klebepunkt bzw. die Klebepunkte sehr klein sein können und der Klebstoff besonders wirtschaftlich aufgetragen werden kann. Auch für Bauelemente mit einem Abstand zwischen Gehäuseunterseite und Anschlußebene bzw. mit einem vorzusehenden Bodenabstand, z.B. bei integrierten SMD-Schaltungen, ist das Aufbringen des Klebstoffs auf die Lötstoppmaske einfacher und wirtschaftlicher als das Aufbringen auf die Leiterplatte, zumal die Lötstoppmaske auch nicht entfernt werden muß.

Nachdem das Bauelement mit der Leiterplatte fest verbunden ist, wird ein Flußmittel aufgebracht. Bei problematisch lötbaren Bauelementen kann dazu in üblicher Weise ein Flußmittel verwendet werden, das vergleichsweise aggressiv ist und deshalb nach dem Lötvorgang ein Waschen erfordert. Da andererseits die Erfindung den Vorteil besitzt, daß das Flußmittel nicht gleichzeitig das Bauelement 5 halten muß, kann auch ein wenig aggressives Flußmittel verwendet werden, beispielsweise ein Low-Solid (LS)-Flußmittel. Derartige Flußmittel konnten bisher in der Reflow-Technik nicht benutzt werden. Vorteilhafterweise wird das Flußmittel aufgebracht, indem die Leiterplatte mit den befestigten Bauelementen getaucht wird. Dabei werden nicht nur die elektrischen Anschlüsse des Bauelements 5 und die Lotaufträge mit Flußmittel benetzt, sondern auch das Bauelement selbst. Beim späteren Lötvorgang ergibt sich damit eine bessere Lötverbindung. Weiterhin können bei beidseitig bestückten Leiterplatten beide Seiten gleichzeitig mit Flußmittel benetzt werden. Ein LS-Flußmittel bietet den Vorteil, daß es nach einem Lötvorgang nicht wieder abgewaschen werden muß. Das Flußmittel kann auch nach einem anderen Verfahren, beispielsweise durch Sprühen aufgebracht werden.

Nach dem Aufbringen des Flußmittels erfolgt in gewohnter Weise der Lötvorgang, indem die Lotaufträge erwärmt werden. Die fertigen Lötverbindungen 7 kontaktieren das Bauelement 5 mit den leitfähigen Bereichen 2.

Das erfindungsgemäße Verfahren eignet sich für alle Arten von Leiterplatten und sonstige Basismaterialien. Die Weiterverarbeitung kann auf üblichen Wegen erfolgen. Das Verfahren hat den Vorteil, daß die vorbereitete Leiterplatte vergleichsweise lange lagerfähig ist, da in den Lotaufträgen keine zusätzlichen Flußmittel und Klebeanteile enthalten sind. Dadurch kann die vorbereitete Leiterplatte mit den Lotaufträgen problemlos vor dem nachfolgenden Tauchvorgang geprüft werden. Darüber hinaus bietet das Verfahren den Vorteil, daß bei dem Trend zu immer feineren Anschlußkonfigurationen vergleichsweise hohe Lotschichten 3 ermöglicht sind, die aus Toleranzgründen vorteilhaft ist. Die Dicke der Lotaufträge 3 kann zwischen 20 und 300 µm liegen. Nach der Herstellung der Lotaufträge kann die Leiterplatte nicht nur überprüft werden, sondern gegebenenfalls auch eine Reinigung vor der Weiterverarbeitung vorgesehen sein.

## Patentansprüche

1. Verfahren zum Beloten und Montieren von Leiterplatten mit Bauelementen, mit folgenden Schritten:
a) auf elektrisch leitfähige Bereiche (2) einer Leiterplatte (1) werden Lotdepots aufgebracht,
b) ein Bauelement (5) wird mit Hilfe eines Klebstoffs (6) mit der Leiterplatte derart verbunden, daß der Klebstoff auf der Leiterplatte zwischen jeweils dem Bauelement (5) zuordnenbaren elektrisch leitfähigen Bereichen (2) angeordnet ist,
c) ein Flußmittel wird aufgebracht,
d) das Bauelement wird mit den elektrisch leitfähigen Bereichen verlötet,
**dadurch gekennzeichnet,**
e) daß vor Schritt b) aus den Lotdepots durch Aufschmelzen zunächst Lotaufträge gebildet werden, die
f) danach unter Erwärmung eingeebnet werden, und
g) daß der Verfahrensschritt d) durch Aufschmelzen der eingeebneten Lotaufträge erfolgt.

2. Verfahren nach Anspruch 1,
**dadurch gekennzeichnet,**
daß der Klebstoff (6) als Klebepunkt pro Bauelement aufgebracht wird.

3. Verfahren nach einem der Ansprüche 1 bis 2,
**dadurch gekennzeichnet,**
daß der Klebstoff (6) mit einer Maske aufgebracht wird.

4. Verfahren nach einem der Ansprüche 1 bis 2,
**dadurch gekennzeichnet,**
daß der Klebstoff mit einem Dosiergerät aufgebracht wird.

5. Verfahren nach einem der Ansprüche 1 bis 4,
**dadurch gekennzeichnet,**
daß die Bauelemente (5) mit der Leiterplatte (1) durch Aushärten des Klebstoff (6) verbunden werden.

6. Verfahren nach einem der Ansprüche 1 bis 5,
**dadurch gekennzeichnet,**
daß das Flußmittel durch Tauchen der mit aufgeklebten Bauelementen (5) bestückten Leiterplatte (1) aufgebracht wird.

7. Verfahren nach einem der Ansprüche 1 bis 5,
**dadurch gekennzeichnet,**
daß das Flußmittel durch Sprühen auf die mit aufgeklebten Bauelementen (5) bestückte Leiterplatte aufgebracht wird.

8. Verfahren nach einem der Ansprüche 1 bis 7,
**dadurch gekennzeichnet,**
daß als Flußmittel ein Low Solid (LS)-Flußmittel verwendet wird.

9. Verfahren nach einem der vorhergehenden Ansprüche,
**dadurch gekennzeichnet,**
daß als Bauelement (5) SMD-Bauelemente eingesetzt werden, die auf die Leiterplatte (1) oder eine Lötstoppmaske (4) geklebt werden.

## Claims

1. Method for applying solder to and mounting components on printed circuit boards, having the following steps:
a) solder deposits are applied to electrically conductive regions (2) of a printed circuit board (1),
b) a component (5) is connected with the aid of an adhesive (6) to the printed circuit board in such a way that the adhesive is arranged on the printed circuit board between electrically conductive regions (2) which can be respectively assigned to the component (5),
c) a flux is applied,
d) the component is soldered to the electrically conductive regions,
characterized
e) in that, prior to step b), solder applications are initially formed from the solder deposits by melting and
f) afterwards are levelled with heating, and
g) in that the method step d) is effected by melting the levelled soldered application.

2. Method according to Claim 1, characterized in that the adhesive (6) is applied as an adhesive spot per component.

3. Method according to either of Claims 1 and 2, characterized in that the adhesive (6) is applied with a mask.

4. Method according to either of Claims 1 and 2, characterized in that the adhesive is applied with a metering device.

5. Method according to one of Claims 1 to 4, characterized in that the components (5) are connected to the printed circuit board (1) by curing the adhesive (6).

6. Method according to one of Claims 1 to 5, characterized in that the flux is applied by immersing the printed circuit board (1) populated with bonded-on components (5).

7. Method according to one of Claims 1 to 5, characterized in that the flux is applied by spraying onto the printed circuit board populated with bonded-on components (5).

8. Method according to one of Claims 1 to 7, characterized in that the flux used is a low solid (LS) flux.

9. Method according to one of the preceding claims, characterized in that SMD components which are bonded onto the printed circuit board (1) or a solder resist mask (4) are used as the components (5).

## Revendications

1. Procédé pour munir des plaquettes à circuits imprimés de métal d'apport de brasage et y fixer des composants, comportant les étapes suivantes:
a) on dépose sur des zones (2) conductrices de l'électricité d'une plaquette (1) à circuits imprimés des dépôts de métal d'apport de brasage,
b) à l'aide d'une colle (6), on relie un composant (5) à la plaquette à circuits imprimés de manière que la colle soit disposée sur la plaquette à circuits imprimés entre des zones (2) conductrices de l'électricité, pouvant être associées chacune au composant (5),
c) on dépose un flux,
d) on brase le composant aux zones conductrices de l'électricité,
caractérisé en ce que
e) avant l'étape b), on forme par fusion des dépôts de métal d'apport de brasage d'abord des couches de métal d'apport de brasage,
f) on aplanit ensuite ces couches de métal d'apport par chauffage et
g) on effectue l'étape d) opératoire par fusion des couches de métal d'apport de brasage aplanies.

2. Procédé suivant la revendication 1, caractérisé en ce que l'on dépose la colle (6) sous forme de point de colle par composant.

3. Procédé suivant l'une des revendications 1 à 2, caractérisé en ce que l'on dépose la colle (6) par un masque.

4. Procédé suivant l'une des revendications 1 à 2, caractérisé en ce que l'on dépose la colle (6) par un doseur.

5. Procédé suivant l'une des revendications 1 à 4, caractérisé en ce que l'on relie les composants (5) à la plaquette (1) à circuits imprimés en durcissant la colle (6).

6. Procédé suivant l'une des revendications 1 à 5, caractérisé en ce que l'on dépose le flux par trempage de la plaquette (1) à circuits imprimés munie de composants (5) collés.

7. Procédé suivant l'une des revendications 1 à 5, caractérisé en ce que l'on dépose le flux par pulvérisation sur la plaquette à circuits imprimés munie de composants (5) collés.

8. Procédé suivant l'une des revendications 1 à 7, caractérisé en ce que l'on utilise comme flux un flux Low Solid (LS).

9. Procédé suivant l'une des revendications précédentes, caractérisé en ce que l'on utilise comme composant (5) des composants montés en surface, qui sont collés à la plaquette (1) à circuits imprimés ou à un masque d'arrêt de brasage.
